(19) Europäisches Patentamt European Patent Office Office européen des brevets

(11) **EP 4 354 246 B1**

(12) **EUROPEAN PATENT SPECIFICATION**

(45) Date of publication and mention
of the grant of the patent:
**17.06.2026 Bulletin 2026/25**

(21) Application number: **22860810.5**

(22) Date of filing: **24.01.2022**

(51) International Patent Classification (IPC):
**G05D 1/226** (2024.01)   **G05D 1/698** (2024.01)
**G05D 107/70** (2024.01)   **G05D 105/28** (2024.01)
**G05D 109/10** (2024.01)   **B65G 1/00** (2006.01)

(52) Cooperative Patent Classification (CPC):
**G05D 1/6987; G05D 1/2265;** G05D 2105/28;
G05D 2107/70; G05D 2109/14

(86) International application number:
**PCT/JP2022/002459**

(87) International publication number:
**WO 2023/026512 (02.03.2023 Gazette 2023/09)**

(54) **CONVEYANCE SYSTEM**

FÖRDERSYSTEM

SYSTÈME DE TRANSPORT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **27.08.2021 JP 2021139173**

(43) Date of publication of application:
**17.04.2024 Bulletin 2024/16**

(73) Proprietor: **Murata Machinery, Ltd.
Kyoto-shi,
Kyoto 601-8326 (JP)**

(72) Inventors:
• **KITAMURA Wataru
Inuyama-shi, Aichi 484-8502 (JP)**

• **ITO Yasuhisa
Inuyama-shi, Aichi 484-8502 (JP)**

(74) Representative: **Stöckeler, Ferdinand
Schoppe, Zimmermann, Stöckeler
Zinkler, Schenk & Partner mbB
Patentanwälte
Radlkoferstrasse 2
81373 München (DE)**

(56) References cited:
**WO-A1-2020/235196   JP-A- 2004 246 418
JP-A- 2012 099 033   JP-A- 2015 082 574
JP-A- H08 129 419**

## Description

### Technical Field

An aspect of the present invention relates to a conveyance system.

### Background Art

A conveyance system including a plurality of vehicles and a controller configured to control the vehicles is known. As a technique of this kind, JP 2019-012500 A, for example, discloses that a controller communicates with a plurality of vehicles (traveling vehicles) sequentially and periodically.

WO 2020/235196 A1 discloses a traveling vehicle system including a plurality of traveling vehicles, a controller that controls the plurality of transport vehicles, a traveling region of the traveling vehicles having a plurality of blocking sections each of which undergoes exclusive control to prohibit another traveling vehicle from moving thereinto, and the traveling vehicle being controlled so as to be able to occupy and pass through the blocking sections when occupation permissions for the blocking sections are granted by the controller and so as to be prohibited to move into the blocking sections when the occupation permissions are not granted by the controller. The controller communicates with the traveling vehicles using cyclic communication, for example, polling communication.

Another example of conveyance system is provided by the disclosure JP 2004 246418 A.

### Summary of Invention

### Technical Problem

In the system described above, for example, as the number of vehicles increases, the cycle of periodic communication for communicating with the vehicles sequentially and periodically (what is called polling communication) becomes longer, and it may be difficult to communicate sufficiently with each vehicle.

It is an object of an aspect of the present invention to provide a conveyance system that can shorten the cycle of periodic communication for communicating with a plurality of vehicles sequentially and periodically.

### Solution to Problem

A conveyance system according to an aspect of the present invention is a conveyance system including: a plurality of vehicles; and a system controller configured to control the vehicles, in which each vehicle of the plurality of vehicles comprises a vehicle controller configured to control the vehicle, the vehicle controller being configured to generate and update state information and to transmit the state information to the system controller, the system controller performs periodic communication for communicating with the vehicles sequentially and periodically, and when at least one of the vehicles is in a predetermined operating state, the system controller stops communicating with the at least one of the vehicles in the periodic communication or reduces a frequency of communication with the at least one of the vehicles in the periodic communication.

In this conveyance system, time required for communication with a vehicle in the predetermined operating state can be reduced in the periodic communication for communicating with the vehicles sequentially and periodically (hereinafter, also simply referred to as "periodic communication"). Thus, the cycle of the periodic communication can be shortened.

In the conveyance system according to an aspect of the present invention, the predetermined operating state may include a first operating state in which the vehicle stops traveling and performs an operation other than traveling. In this case, time required for communication with the vehicle in the first operating state in the periodic communication can be reduced.

In the conveyance system according to an aspect of the present invention, communication with the vehicle in the first operating state in the periodic communication may be stopped for a period based on time required for an operation in the first operating state. In this case, the cycle of the periodic communication can be reduced for the period based on the time required for the operation in the first operating state.

In the conveyance system according to an aspect of the present invention, the first operating state may include a transferring state that is a state from when the vehicle starts transferring an article until just before completing the transferring. In this case, the time required for communication with the vehicle in the transferring state in the periodic communication can be reduced.

In the conveyance system according to an aspect of the present invention, the first operating state may include a charging state that is a state from when the vehicle starts being charged until just before completing being charged. In this case, the time required for communication with the vehicle in the charging state in the periodic communication can be reduced.

In the conveyance system according to an aspect of the present invention, the first operating state may include a turning state that is a state from when the vehicle starts turning until just before a timing when the vehicle needs to request blocking control to prohibit another vehicle from entering a predetermined area into which the vehicle enters after the turning. In this case, the time required for communication with the vehicle in the turning state in periodic communication can be reduced.

In the conveyance system according to an aspect of the present invention, the predetermined operating state may include a second operating state in which the vehicle stops traveling due to an influence of an operation of another vehicle. In this case, the time required for communication with the vehicle in the second operating state in the periodic communication can be reduced.

In the conveyance system according to an aspect of the present invention, communication with the vehicle in the second operating state in the periodic communication may be stopped while the influence of the operation of the other vehicle is being exerted, or until just before the influence disappears. In this case, the cycle of the periodic communication can be reduced for the period when the influence of the operation of the other vehicle is being exerted, or the period until just before the influence disappears.

In the conveyance system according to an aspect of the present invention, the second operating state may include a transfer wait state that is a state in which the vehicle stops traveling from when the other vehicle starts transferring an article until just before completing the transferring. In this case, the time required for communication with the vehicle in the transfer wait state in the periodic communication can be reduced.

In the conveyance system according to an aspect of the present invention, the second operating state may include a blocking wait state that is a state from when the vehicle starts to stop traveling until just before ending the stopping in accordance with blocking control that is control requested by the other vehicle and that prohibits the vehicle other than the other vehicle from entering a predetermined area. In this case, the time required for communication with the vehicle in the blocking wait state in the periodic communication can be reduced.

In the conveyance system according to an aspect of the present invention, the second operating state may include an area-entry wait state that is a state from when the vehicle starts to stop traveling until just before ending the stopping in accordance with area number limit control for, when the number of other vehicles present in one of a plurality of traveling areas is a specified number or more, prohibiting entry into the corresponding traveling area. In this case, the time required for communication with the vehicle in the area-entry wait state in the periodic communication can be reduced.

In the conveyance system according to an aspect of the present invention, the predetermined operating state may include a third operating state in which the vehicle is performing an operation set for an indefinite period. In this case, the time required for communication with the vehicle in the third operating state in the periodic communication can be reduced.

In the conveyance system according to an aspect of the present invention, the frequency of communication with the vehicle in the third operating state in the periodic communication may be reduced. In this case, the frequency of reducing the cycle for the time required for communication with the vehicle in the third operating state can be increased in the periodic communication.

In the conveyance system according to an aspect of the present invention, the third operating state may include an under-maintenance state that is a state in which the vehicle is executing a maintenance mode. In this case, the time required for communication with the vehicle in the under-maintenance state in the periodic communication can be reduced.

In the conveyance system according to an aspect of the present invention, the third operating state may include an error stop state that is a state in which the vehicle is at a standstill due to an error. In this case, the time required for communication with the vehicle in the error stop state in the periodic communication can be reduced.

In the conveyance system according to an aspect of the present invention, the third operating state may include an idle stop state that is a state in which the vehicle is at a standstill in an idle state. In this case, the time required for communication with the vehicle in the idle stop state in the periodic communication can be reduced.

The conveyance system according to an aspect of the present invention may include a grid-patterned track on which the vehicles travel. In this case, what is called a grid system can be configured. By this configuration, traveling paths for the vehicle can be selected easily and flexibly, whereby traffic congestion can be prevented and conveyance efficiency can be improved.

**Advantageous Effects of Invention**

According to an aspect of the present invention, it is possible to provide the conveyance system that can shorten the cycle of the periodic communication for communicating with the vehicles sequentially and periodically.

**Brief Description of Drawings**

[FIG. 1] FIG. 1 is a perspective view illustrating an example of a conveyance system according to an embodiment.
[FIG. 2] FIG. 2 is a perspective view illustrating an example of a vehicle in FIG. 1.
[FIG. 3] FIG. 3 is a side view illustrating an example of the vehicle in FIG. 1.
[FIG. 4] FIG. 4 is a block diagram illustrating the conveyance system in FIG. 1.
[FIG. 5] FIG. 5(a) is a flowchart illustrating a process of skipping a transferring vehicle. FIG. 5(b) is a flowchart illustrating a process of skipping a vehicle being charged. FIG. 5(c) is a flowchart illustrating a process of skipping a turning vehicle.
[FIG. 6] FIG. 6(a) is a flowchart illustrating a process of skipping a vehicle waiting for transfer. FIG. 6(b) is a flowchart illustrating a process of skipping a vehicle waiting due to blocking. FIG. 6(c) is a flowchart illustrating a process of skipping a vehicle waiting for area entry.
[FIG. 7] FIG. 7(a) is a flowchart illustrating a process of skipping a vehicle under maintenance. FIG. 7(b) is a flowchart illustrating a process of skipping an error stop vehicle. FIG. 7(c) is a flowchart illustrating a process of skipping an idle stop vehicle.

## Description of Embodiments

An embodiment will now be described with reference to the drawings. In description of the drawings, like elements are designated by like reference signs, and duplicate description is omitted.

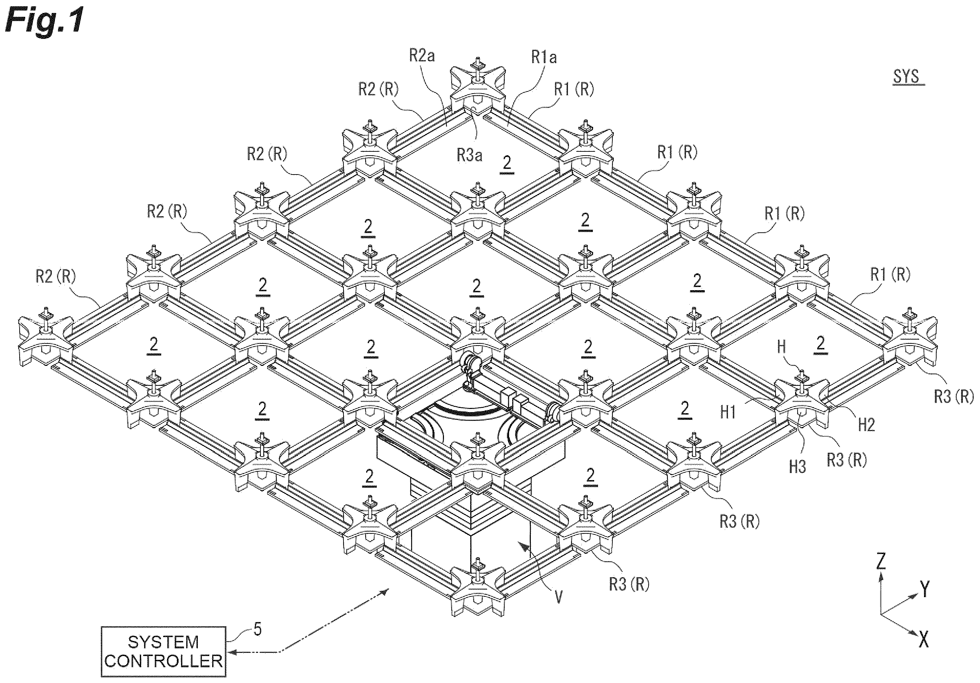

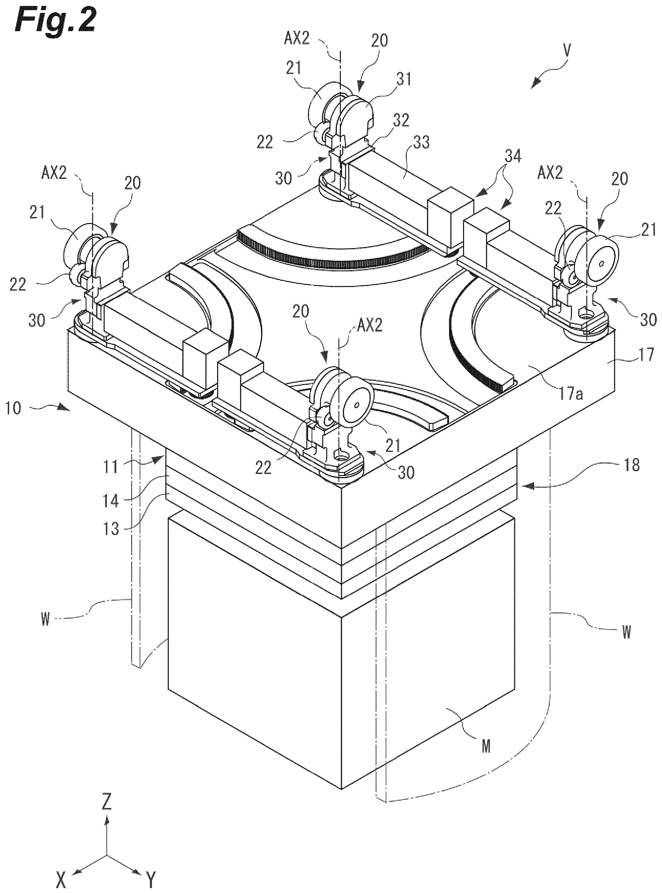

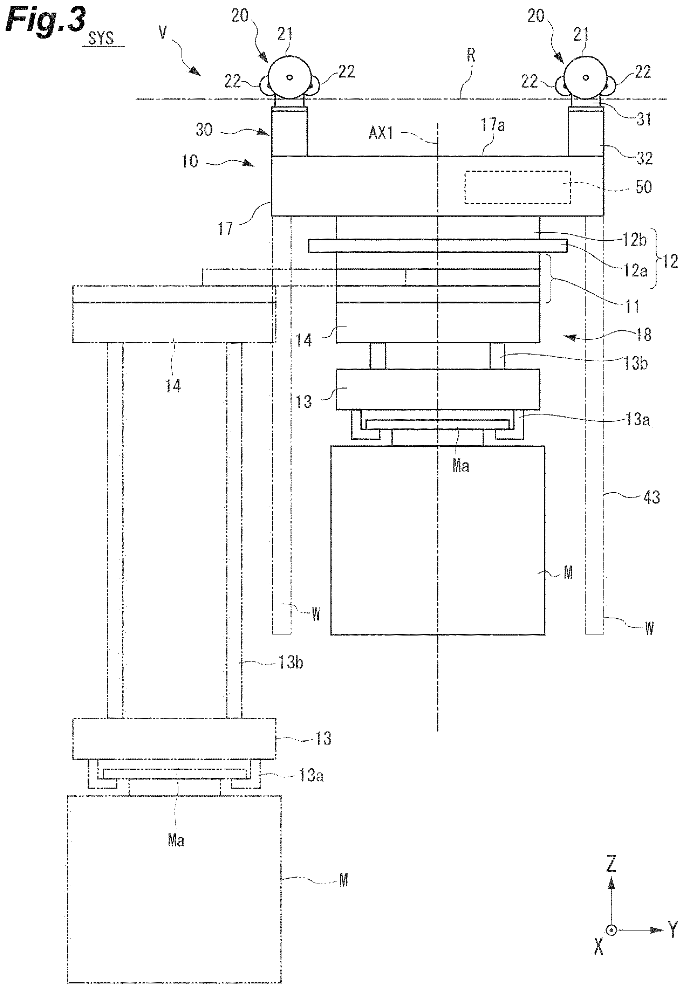

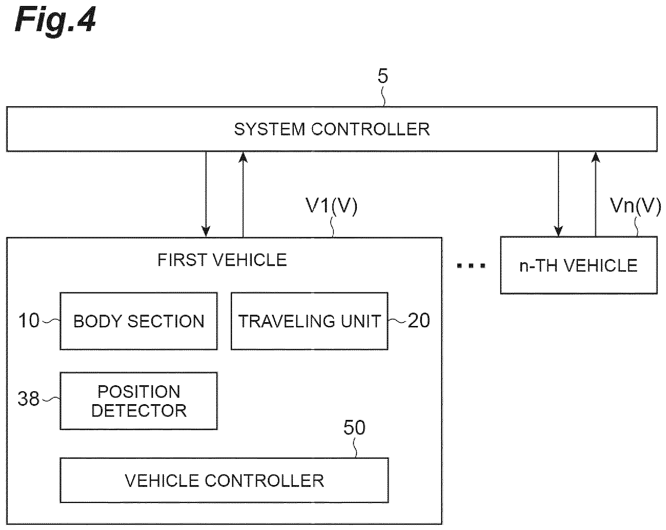

FIG. 1 is a perspective view illustrating an example of a conveyance system SYS according to the embodiment. FIG. 2 is a perspective view of a vehicle V to be used in the conveyance system SYS in FIG. 1. FIG. 3 is a side view illustrating the vehicle V in FIG. 2. FIG. 4 is a block diagram illustrating the conveyance system SYS in FIG. 1. In the drawings, the scale will be changed to be expressed appropriately for convenience of explanation. In the following description, one direction along a horizontal plane is denoted as the X direction, a direction orthogonal to the X direction and along the horizontal plane is denoted as the Y direction, and the vertical direction is denoted as the Z direction.

The conveyance system SYS is a grid system for conveying an article M by a vehicle V in a clean room of a semiconductor manufacturing factory, for example. The conveyance system SYS includes: a first vehicle V1 to an n-th vehicle Vn (hereinafter, collectively referred to as "vehicles V") (see FIG. 4); a system controller 5 configured to control a plurality of the vehicles V; and a rail R on which the vehicles V travel. In the present embodiment, an example in which each vehicle V is an overhead vehicle will be described. The vehicle V moves along a rail R of the conveyance system SYS. The rail R is a traveling path for the vehicle V. The vehicle V moves along the rail R of the conveyance system SYS, and conveys an article M such as a FOUP configured to accommodate semiconductor wafers or a reticle pod configured to accommodate reticles. The vehicle V may be referred to as a conveyance vehicle, a conveyance carrier, a traveling vehicle, or a traveling carrier.

The rail R is installed on a ceiling of a building such as a clean room or near the ceiling. The rail R is provided adjacently to, for example, processing devices, a stocker (automatic warehouse), and the like. The processing devices are, for example, photolithography equipment, a coater/developer, deposition equipment, etching equipment, and the like, and perform various kinds of processing on the semiconductor wafers in the article M to be conveyed by the vehicle V. The stocker stores the article M to be conveyed by the vehicle V. The rail R is an example of a form of a track. The rail R is a grid-patterned track arranged in a grid pattern in plan view. The rail R is a rail extending along a horizontal direction and suspended. The rail R is a grid-patterned rail including a plurality of first rails R1, a plurality of second rails R2, and a plurality of intersection parts R3.

The first rails R1 each extend along the X direction. The second rails R2 each extend along the Y direction. The rail R is formed in a grid pattern in plan view by the first rails R1 and the second rails R2. The rail R forms a plurality of matrix elements with the first rails R1 and the second rails R2. The intersection parts R3 are disposed at portions corresponding to intersections of the first rails R1 and the second rails R2. Each intersection part R3 is adjacent to the corresponding first rails R1 in the X direction and adjacent to the corresponding second rails R2 in the Y direction. The intersection parts R3 are connecting tracks connecting each first rail R1 to the corresponding second rail R2, connecting the first rails R1 to each other, and the second rails R2 to each other. The intersection parts R3 are tracks to be used in any case when the vehicle V travels along first rails R1, when the vehicle V travels along second rails R2, or when the vehicle V travels from first rails R1 to second rails R2 or from second rails R2 to first rails R1.

In the rail R, the first rails R1 and the second rails R2 are provided in orthogonal directions, whereby a plurality of grid cells 2 are arranged adjacent to each other in plan view. One grid cell 2 corresponds to one matrix element and is a rectangular area surrounded by two first rails R1 adjacent in the Y direction and two second rails R2 adjacent in the X direction in plan view. In FIG. 1, part of the rail R is illustrated, and the same configuration of the rail R is formed continuously in the X direction and the Y direction from the illustrated configuration.

The first rails R1, the second rails R2, and the intersection parts R3 are suspended from a ceiling (not illustrated) by suspending members H (see FIG. 1). Each suspending member H has first portions H1 for suspending first rails R1, second portions H2 for suspending second rails R2, and a third portion H3 for suspending an intersection part R3. The first portions H1 and the second portions H2 are each formed at two locations with the third portion H3 interposed therebetween.

The first rails R1, the second rails R2, and the intersection parts R3 have traveling surfaces R1a, R2a, and R3a, respectively, on which traveling wheels 21 (described later) of the vehicle V travel. A gap is formed each between each first rail R1 and the corresponding intersection part R3 and between each second rail R2 and the corresponding intersection part R3. The gaps between the first rail R1 and the intersection part R3 and between the second rail R2 and the intersection part R3 are spaces through which a coupling section 30 described later, which is a part of a vehicle V, passes when the vehicle V travels on a first rail R1 and crosses a second rail R2, or when it travels on a second rail R2 and crosses a first rail R1. Thus, the gaps between the first rail R1 and the intersection part R3 and between the second rail R2 and the intersection part R3 are formed in a width through which the coupling section 30 can pass.

The first rails R1, the second rails R2, and the intersection parts R3 are provided along the same horizontal plane.

The conveyance system SYS includes a communication system (not illustrated). The communication system is used for communication between the vehicle V and the system controller 5. The vehicle V and the system controller 5 are connected in a manner capable of communicating with each other via the communication system.

The following describes a configuration of the vehicle V. As illustrated in FIGS. 2 to 4, the vehicle V is provided to be able to travel along the rail R. The vehicle V includes a body section 10, a traveling unit 20, the coupling section 30, and a vehicle controller 50.

The body section 10 is disposed below the rail R. The body section 10 is formed in a rectangular shape, for example, in plan view. The body section 10 is formed to have dimensions that fit into one grid cell 2 (see FIG. 1) in the rail R in plan view. This provides space for the vehicle V to pass another one traveling on the adjacent first rail R1 or the adjacent second rail R2. The body section 10 includes an upper unit 17 and a transfer device 18. The upper unit 17 is suspended from the traveling unit 20 with the coupling section 30 interposed therebetween. The upper unit 17 is rectangular in plan view, for example, and has four corners on an upper surface 17a thereof.

The body section 10 includes, on each of its four corners, a traveling wheel 21, the coupling section 30, and a direction-changing mechanism 34. In this configuration, the traveling wheels 21 disposed at the four corners of the body section 10 allow the body section 10 to be suspended stably and the body section 10 to travel stably.

The transfer device 18 moves along the horizontal direction with respect to the traveling unit 20 to transfer an article to and from a load port (placement platform). The transfer device 18 is provided below the upper unit 17. The transfer device 18 can rotate about a rotation axis AX1 in the Z direction. The transfer device 18 includes an article holding unit 13 configured to hold an article M below the rail R, a lifting drive unit 14 configured to raise and lower the article holding unit 13 in the vertical direction, a lateral feed mechanism 11 configured to slide and move the lifting drive unit 14 in the horizontal direction, and a turning unit 12 configured to hold the lateral feed mechanism 11. The load port is a transfer destination or a transfer source of the vehicle V, and is a location where an article M is delivered to or received from the vehicle V.

The article holding unit 13 grips a flange Ma of an article M, thereby suspending and holding the article M. The article holding unit 13 is, for example, a chuck including claws 13a that can move horizontally. By causing the claws 13a to proceed to below the flange Ma of the article M and raising the article holding unit 13, the article M is held. The article holding unit 13 is connected to suspending members 13b such as wires or belts.

The lifting drive unit 14 is a hoist, for example, which lowers the article holding unit 13 by paying out the suspending members 13b, and raises the article holding unit 13 by winding the suspending members 13b. The lifting drive unit 14 is controlled by the vehicle controller 50 to lower or raise the article holding unit 13 at a predetermined speed. The lifting drive unit 14 is controlled by the vehicle controller 50 to hold the article holding unit 13 at a target height.

The lateral feed mechanism 11 includes a plurality of movable plates disposed in a manner stacked in the Z direction, for example. To the lowermost movable plate, the lifting drive unit 14 is attached. In the lateral feed mechanism 11, the movable plates move in a direction perpendicular to the traveling direction of the vehicle V in the horizontal plane, and the lifting drive unit 14 attached to the lowermost movable plate and the article holding unit 13 are fed (slid and moved) in the direction perpendicular to the traveling direction of the vehicle V.

The turning unit 12 is provided between the lateral feed mechanism 11 and the upper unit 17. The turning unit 12 includes a turning member 12a and a turning drive unit 12b. The turning member 12a is provided to be able to turn about an axis in the Z direction. The turning member 12a supports the lateral feed mechanism 11. The turning drive unit 12b, for which an electric motor or the like is used, turns the turning member 12a about the rotation axis AX1. The turning unit 12 turns the turning member 12a by the driving force from the turning drive unit 12b, thereby being able to rotate the lateral feed mechanism 11 (the lifting drive unit 14 and the article holding unit 13) about the rotation axis AX1. The vehicle V can deliver and receive an article M to and from the load port by using the transfer device 18.

As illustrated in FIGS. 2 and 3, the vehicle V may be provided with a cover W. The cover W surrounds the transfer device 18 and the article M held by the transfer device 18. The cover W has a tubular shape that is open at the lower end thereof, and has such a shape that a portion thereof through which the movable plates of the lateral feed mechanism 11 protrude is recessed. The cover W, the upper end of which is attached to turning member 12a of the turning unit 12, turns about the rotation axis AX1 as the turning member 12a turns.

The traveling unit 20 includes the traveling wheels 21 and auxiliary wheels 22. The traveling wheels 21 are disposed at the respective four corners of the upper surface 17a of the upper unit 17 (the body section 10). Each traveling wheel 21 is attached to an axle provided to the corresponding coupling section 30. Each traveling wheel 21 is rotationally driven by the driving force of a traveling drive unit 33. Each traveling wheel 21 rolls on the rail R. The respective traveling wheels 21 roll on the traveling surfaces R1a, R2a, R3a of the first rails R1, the second rails R2, and the intersection parts R3, thereby causing the vehicle V to travel. Herein, all of the four traveling wheels 21 do not necessarily have to be rotationally driven by the driving force of the traveling drive unit 33, and some of the four traveling wheels 21 may be configured to be rotationally driven.

Each traveling wheel 21 is provided to be able to pivot in a θZ direction about a pivot axis AX2. The traveling wheel 21 pivots in the θZ direction by the corresponding direction-changing mechanism 34 described later, and consequently can change the traveling direction of the vehicle V. The auxiliary wheels 22 are disposed each in front of and rear of the traveling wheel 21 in the traveling direction. Each of the auxiliary wheels 22 can rotate about the axis of the axle that is parallel or substantially parallel along the XY plane in the same manner as the traveling wheel 21. The lower ends of the auxiliary wheels 22 are set higher than the lower end of the traveling wheel 21. Thus, when the traveling wheel 21 is traveling on the traveling surfaces R1a, R2a, R3a, the auxiliary wheels 22 do not come into contact with the traveling surfaces R1a, R2a, R3a. When the traveling wheel 21 passes over the gaps between the first rail R1 and the intersection part R3 and between the second rail R2 and the intersection part R3, the auxiliary wheels 22 come into contact with the traveling surfaces R1a, R2a, R3a to prevent the traveling wheel 21 from falling. Herein, two auxiliary wheels 22 do not necessarily have to be provided to one traveling wheel 21. For example, one auxiliary wheel 22 may be provided on one traveling wheel 21, or no auxiliary wheel 22 may be provided.

As illustrated in FIG. 2, the coupling sections 30 couple the upper unit 17 of the body section 10 to the traveling unit 20. The coupling sections 30 are provided at the respective four corners of the upper surface 17a of the upper unit 17 (the body section 10). By these coupling sections 30, the body section 10 is suspended from the traveling unit 20 and disposed below the rail R. Each coupling section 30 includes a support member 31 and a connecting member 32. The support member 31 rotatably supports the rotating shaft of the corresponding traveling wheel 21 and the rotating shafts of the corresponding auxiliary wheels 22. The support member 31 maintains the relative position between the traveling wheel 21 and the auxiliary wheels 22. The support member 31 is formed in a platelike shape, for example, and is formed to have a thickness capable of passing through the gaps between the first rail R1 and the intersection part R3 and between the second rail R2 and the intersection part R3.

The connecting member 32 extends downward from the support member 31 and is coupled to the upper surface 17a of the upper unit 17 to hold the upper unit 17. The connecting member 32 includes inside a transmission mechanism configured to transmit the driving force of the traveling drive unit 33 described later to the traveling wheel 21. This transmission mechanism may have a configuration using a chain or a belt, or may have a configuration using a gear train. The connecting member 32 is provided to be able to pivot in the θZ direction about the pivot axis AX2. This connecting member 32 pivots about the pivot axis AX2, thereby being able to pivot the traveling wheel 21 in the θZ direction about the pivot axis AX2 with the support member 31 interposed therebetween.

Each coupling section 30 (see FIG. 2) is provided with the traveling drive unit 33 and the direction-changing mechanism 34. The traveling drive unit 33 is mounted on the corresponding connecting member 32. The traveling drive unit 33 is a driving source configured to drive the traveling wheel 21 and, for example, an electric motor is used therefor. Each of the four traveling wheels 21 is driven by the corresponding traveling drive unit 33 to serve as a driving wheel. The four traveling wheels 21 are controlled by the vehicle controller 50 to have the same rotation speed.

The direction-changing mechanism 34 pivots the traveling wheel 21 in the direction θZ about the pivot axis AX2 by pivoting the connecting member 32 of the coupling section 30 about the pivot axis AX2. By pivoting the traveling wheel 21 in the θZ direction, the vehicle V can be turned (switch from a first state in which the traveling direction thereof is the X direction to a second state in which the traveling direction is the Y direction, or from the second state in which the traveling direction is the Y direction to the first state in which the traveling direction is the X direction). By this pivoting of the direction-changing mechanism 34, each of the traveling wheels 21 and the auxiliary wheels 22 disposed at the four corners of the upper surface 17a is pivoted within a range of 90 degrees in the θZ direction about the pivot axis AX2. The driving of the direction-changing mechanism 34 is controlled by the vehicle controller 50. By pivoting the traveling wheels 21 and the auxiliary wheels 22, the traveling wheels 21 shift from a state of being in contact with one of the first rails R1 and the second rails R2 to a state of being in contact with the other. This allows the vehicle V to switch between the first state in which the traveling direction thereof is the X direction and the second state in which the traveling direction is the Y direction, that is, the vehicle V can be turned. In the turning of the vehicle V in the present embodiment, the vehicle V stops traveling. This stopping traveling is, for example, a state in which the article M to be conveyed is not moving.

The vehicle V includes a position detector 38 configured to detect position information (see FIG. 4). The position detector 38 detects the current position of the vehicle V by detecting a position marker (not illustrated) indicating the position information. The position detector 38 detects the position marker in a noncontact manner. The position marker is installed for each grid cell 2 of the rail R.

The vehicle controller 50 collectively controls the vehicle V. The vehicle controller 50 is a computer including a central processing unit (CPU), a read only memory (ROM), and a random access memory (RAM). The vehicle controller 50 can be configured, for example, as software such that a program stored in the ROM is loaded into the RAM to be executed by the CPU. The vehicle controller 50 may be configured as hardware such as an electronic circuit. The vehicle controller 50 may be configured with a single device, or may be configured with a plurality of devices. If it is configured with a plurality of devices, they are connected via a communication network such as the Internet or an intranet to logically construct a single vehicle controller 50. The vehicle controller 50 is provided to the body section 10 in the present embodiment (see FIG. 3), but may be provided outside the body section 10.

The vehicle controller 50 controls traveling of the vehicle V on the basis of conveyance instructions. The vehicle controller 50 controls the traveling of the vehicle V by controlling the traveling drive unit 33 and the direction-changing mechanism 34, for example. The vehicle controller 50 controls, for example, traveling speed, operations related to stopping, and operations related to changing directions. The vehicle controller 50 controls traveling of the vehicle V such that it does not enter a traveling area where the number of vehicles V present therein is a specified number or more, a blocking area, and an area for transfer (see below for details), in response to instructions from the system controller 5.

The vehicle controller 50 controls a transfer operation of the vehicle V on the basis of conveyance instructions. The vehicle controller 50 controls the transfer operation of the vehicle V by controlling the transfer device 18, for example. The vehicle controller 50 controls an operation of gripping an article M to be placed on a specified load port, and an operation of unloading the held article M onto the specified load port. The vehicle controller 50 generates and updates state information (not illustrated) periodically. The state information is stored in a storage unit 51. The vehicle controller 50 transmits the state information to the system controller 5. The state information includes, for example, information on the current position of the vehicle V, information indicating the current state of the vehicle V such as normal or abnormal, the amount of charge of the vehicle V, and information on the state (execution in progress, execution completed, or execution failed) of various instructions such as conveyance instructions executed by the vehicle V. The vehicle controller 50 transmits a request for blocking control to the system controller 5 when the article M is transferred.

The system controller 5 is a computer including a CPU, a ROM, and a RAM. The system controller 5 can be configured, for example, as software such that a program stored in the ROM is loaded into the RAM to be executed by the CPU. The system controller 5 may be configured as hardware such as an electronic circuit. The system controller 5 may be configured with a single device or a plurality of devices. When it is configured with a plurality of devices, they are connected via a communication network such as the Internet or an intranet to logically construct a single system controller 5. At least some of various controls of the system controller 5 may be performed by the vehicle controller 50.

The system controller 5 selects one of the vehicles V that can convey an article M, and assigns the conveyance instruction to the selected vehicle V. The conveyance instruction includes a traveling instruction for the vehicle V to travel to a load port, and an instruction to grab an article M placed on the load port or an instruction to unload the article M being held onto the load port.

The system controller 5 performs blocking control that is an exclusive control for prohibiting any vehicle V other than the vehicle V from entering a blocking area (predetermined area) through which the vehicle V passes. By this control, traveling of any vehicle V other than the vehicle V is controlled such that it does not to enter the blocking area that it has not been given permission to occupy, and it stops traveling in front of the blocking area and wait, for example. For example, in response to a request for the blocking control from the vehicle controller 50 of a vehicle V, the system controller 5 starts the blocking control and gives permission to occupy the blocking area to this vehicle V. For example, the blocking area is defined by units of grid cells 2 corresponding to matrix elements of the rail R. The blocking area may be a predetermined area into which a vehicle V enters after the vehicle V has turned (changed directions).

At the time of transfer when an article M is transferred to the load port by a vehicle V, the system controller 5 performs blocking control for transfer, which is an exclusive control for prohibiting another vehicle V other than this vehicle V from entering a transfer area required for the transfer. By this control, traveling of the other vehicle V is controlled such that it does not enter the transfer area required for the transfer of the vehicle V, and it stops traveling in front of the transfer area and waits. For example, based on a transfer instruction assigned to the vehicle V, the system controller 5 prohibits another vehicle V from entering the transfer area of the vehicle V. The transfer area corresponds to an area occupied by the vehicle V when an article M is transferred in plan view. For example, the transfer area is defined by units of grid cells 2 corresponding to matrix elements of the rail R.

When the number of vehicles V present in any of a plurality of traveling areas is a specified number or more, the system controller 5 performs an area number limit control for prohibiting entry into the corresponding traveling area. By this control, traveling of the vehicle V is controlled such that it does not enter a traveling area where vehicles V the number of which is the specified number or more are present. Consequently, for example, a vehicle V intending to enter a traveling area, where vehicles V the number of which is the specified number or more are present, stops traveling in front of the traveling area and waits. For example, based on the current position information included in the state information of a plurality of vehicles V, the system controller 5 can determine whether the number of vehicles V present in the traveling area is the specified number or more. The traveling area is an area where the vehicle V can travel and that includes the rail R. A plurality of traveling areas is provided. The specified number is not limited to particular one, and only needs to be a predetermined number. The traveling area is one of a plurality of areas into which an entire area where the vehicle V can travel is divided.

When a vehicle V needs to be charged, the system controller 5 transmits a charging execution instruction, which is an instruction to charge the vehicle V, to the vehicle V. In response to the charging execution instruction, the vehicle V is caused to stop traveling. Whether the vehicle V needs to be charged can be determined based on the state information of the vehicle V. When maintenance of a vehicle V is performed, the system controller 5 transmits a maintenance-mode execution instruction, which is an instruction to execute a maintenance mode, to the vehicle V. The maintenance mode is a mode for performing maintenance on the vehicle V. In the maintenance mode, the vehicle V is caused to travel at low speed or to stop traveling. The maintenance is not limited to a particular one and includes various types of maintenance. For example, the maintenance mode may be a mode for causing the vehicle V to travel remotely in response to a user operation.

When an error has occurred in a vehicle V, the system controller 5 transmits an error stop instruction, which is an instruction to stop traveling of the vehicle V in which the error has occurred, to the vehicle V. Whether an error has occurred in the vehicle V can be determined based on the state information of the vehicle V. When a vehicle V is caused to stop traveling and be in an idle state, the system controller 5 transmits an idling stop instruction, which is an instruction to cause the vehicle V to stop traveling and be in the idle state, to the vehicle V. The idle state is a state in which a vehicle V not traveling is kept ready to quickly start traveling.

Herein, the system controller 5 in the present embodiment performs periodic communication for communicating with a plurality of vehicles V sequentially and periodically (hereinafter, also referred to as "polling communication"). In the polling communication, a plurality of vehicles V that are present within the control range of the system controller 5 are to be communicated with, and communication is performed sequentially for some or all of the vehicles V one by one, and the communication thus sequentially performed is repeatedly performed. When at least one of the vehicles V is in a predetermined operating state, the system controller 5 executes a polling skipping process to stop communication with the at least one of the vehicles V in the polling communication or to reduce the frequency of communication with the at least one of the vehicles V in the polling communication.

The predetermined operating state of a vehicle V on which the polling skipping process is to be executed includes a first operating state in which the vehicle V stops traveling and performs an operation other than traveling. The system controller 5 stops communication with the vehicle V in the first operating state in the polling communication for a period based on the time required for operation in the first operating state.

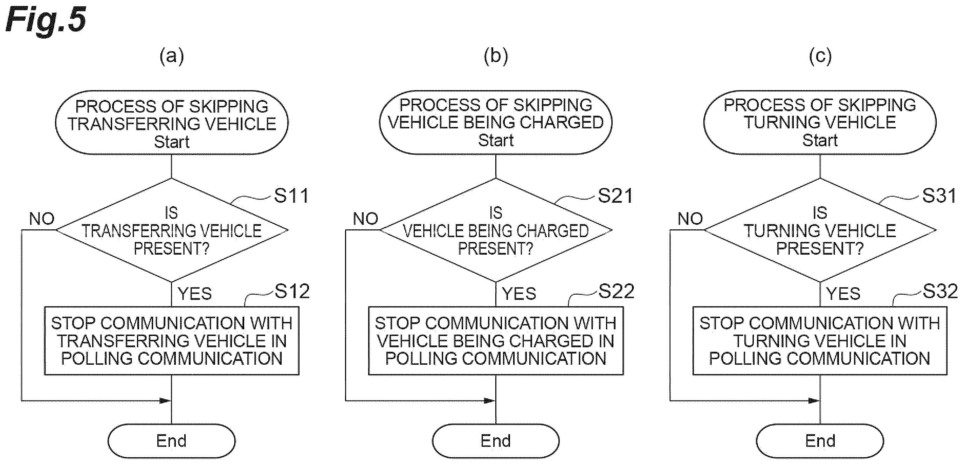

The first operating state includes a transferring state that is a state from when the vehicle V, which has stopped traveling, starts transferring an article M until just before completing the transferring. Specifically, in the polling skipping process, a process of skipping a transferring vehicle, illustrated in FIG. 5(a), is executed periodically and repeatedly.

In the process of skipping a transferring vehicle, it is determined whether a transferring vehicle that is a vehicle V in the transferring state is present among a plurality of vehicles V on which the polling communication is to be performed (step S11). For example, whether the vehicle V is a transferring vehicle may be determined based on the state information of the vehicle V. For example, whether the vehicle V is a transferring vehicle may be determined based on a conveyance instruction assigned to the vehicle V by the system controller 5. For example, whether the vehicle V is a transferring vehicle may be determined based on information or instructions from a host controller (not illustrated). The "just before completing the transferring" in the transferring state is, for example, 100 ms before the timing of completing the transferring. The "just before" is not limited to a particular timing, and means a predetermined period of time earlier (the same applies hereinafter). The state information of the vehicle V may include information on transfer time (a start timing of transfer, an end timing of transfer, and a period required for transfer) of the vehicle V in accordance with a load port for the transfer.

If NO at the above-described step S11, processing in the current cycle is terminated, and the process advances to the step S11 in the next cycle. If YES at the step S11, communication with the transferring vehicle in the polling communication is stopped (step S12). In other words, at this step S12, the transferring vehicle is skipped from among the vehicles V on which the polling communication is to be performed. Consequently, in the polling communication, communication with the vehicles V excluding the transferring vehicle is performed sequentially and periodically.

The first operating state includes a charging state that is a state from when the vehicle V, which has stopped traveling, starts charging with electricity until just before completing the charging. Specifically, in the polling skipping process, a process of skipping a vehicle being charged, illustrated in FIG. 5(b), is executed periodically and repeatedly.

In the process of skipping a vehicle being charged, it is determined whether a vehicle being charged that is a vehicle V in the charging state, is present among the vehicles V on which the polling communication is to be performed (step S21). For example, whether the vehicle V is a vehicle being charged may be determined based on the state information of the vehicle V. For example, whether the vehicle V is a vehicle being charged may be determined based on a charging execution instruction transmitted to the vehicle V by the system controller 5. For example, whether the vehicle V is a vehicle being charged may be determined based on information or instructions from the host controller (not illustrated). The state information of the vehicle V may include information on a start timing of the charging of the vehicle V, an end timing of the charging, and a period required for the charging (e.g., 5 minutes).

If NO at the above-described step S21, the current cycle is terminated, and the process advances to the step S21 in the next cycle. If YES at the step S21, communication with the vehicle being charged in the polling communication is stopped (step S22). In other words, at this step S22, the vehicle being charged is skipped from among the vehicles V on which the polling communication is to be performed. Consequently, in the polling communication, communication with the vehicles V excluding the vehicle being charged is performed sequentially and periodically.

The first operating state includes a turning state that is a state from when the vehicle V starts turning until just before a timing when the vehicle V needs to request blocking control to prohibit another vehicle V from entering a predetermined area (blocking area) into which the vehicle V will enter after the turning. Specifically, in the polling skipping process, a process of skipping a turning vehicle, illustrated in FIG. 5(c), is executed periodically and repeatedly. The request timing of this blocking control may be before the turning operation is completed, and time loss can be eliminated by this timing. The request timing of this blocking control may be after the completion of the turning operation.

In the process of skipping a turning vehicle, it is determined whether a turning vehicle that is a vehicle V in the turning state is present among the vehicles V on which the polling communication is to be performed (step S31). For example, whether the vehicle V is a turning vehicle may be determined based on the state information of the vehicle V. For example, whether the vehicle V is a turning vehicle may be determined based on a conveyance instruction assigned to the vehicle V by the system controller 5. For example, whether the vehicle V is a turning vehicle may be determined based on information or instructions from the host controller (not illustrated). The state information of the vehicle V may include information on a start timing of the turning of the vehicle V, an end timing of the turning, a period required for the turning, and a request timing of the blocking control of the vehicle V.

If NO at the above-described step S31, the current cycle is terminated, and the process advances to the step S31 in the next cycle. If YES at the step S31, communication with the turning vehicle in the polling communication is stopped (step S32). In other words, at this step S32, the turning vehicle is skipped from among the vehicles V on which the polling communication is to be performed. Consequently, in the polling communication, communication with the vehicles V excluding the turning vehicle is performed sequentially and periodically.

The predetermined operating state of a vehicle V on which the polling skipping process to be executed includes a second operating state in which the vehicle V stops traveling due to an influence of an operation of another vehicle V. The system controller 5 stops communication with the vehicle V in the second operating state in the polling communication while the influence of the operation of the other vehicle V is being exerted, or until just before the influence disappears. Hereinafter, the vehicle V with which communication is to be stopped is also referred to as "subject vehicle V".

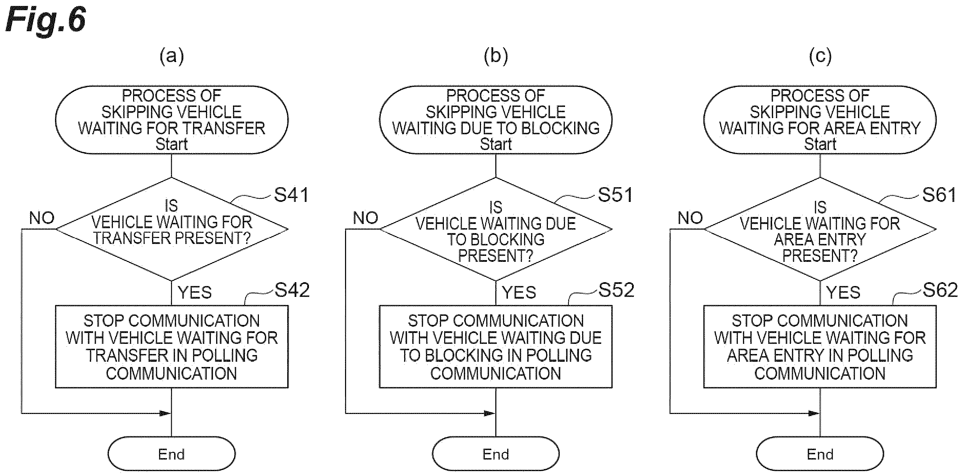

The second operating state includes a transfer wait state that is a state in which the subject vehicle V stops traveling from when the other vehicle V starts transferring an article until just before completing the transferring. Specifically, in the polling skipping process, a process of skipping a vehicle waiting for transfer, illustrated in FIG. 6(a), is executed periodically and repeatedly.

In the process of skipping a vehicle waiting for transfer, it is determined whether a vehicle waiting for transfer that is a subject vehicle V in the transfer wait state is present among the vehicles V on which the polling communication is to be performed (step S41). For example, whether the subject vehicle V is a vehicle waiting for transfer may be determined based on the state information of the subject vehicle V and the other vehicle V. For example, whether the subject vehicle V is a vehicle waiting for transfer may be determined based on instructions of the blocking control for transfer. For example, whether the subject vehicle V is a vehicle waiting for transfer may be determined based on information or instructions from the host controller (not illustrated). The state information of the subject vehicle V and the other vehicle V may include a start timing of transfer of the other vehicle V, an end timing of transfer of the other vehicle V, a time required for transfer of the other vehicle V, a start timing of stopping traveling of the subject vehicle V, and an end timing of stopping traveling of the subject vehicle V.

If NO at the above-described step S41, processing in the current cycle is terminated, and the process advances to the step S41 in the next cycle. If YES at the step S41, communication with the vehicle waiting for transfer in the polling communication is stopped (step S42). In other words, at this step S42, the vehicle waiting for transfer is skipped from among the vehicles V on which the polling communication is to be performed. Consequently, in the polling communication, communication with the vehicles V excluding the vehicle waiting for transfer is performed sequentially and periodically.

The second operating state includes a blocking wait state that is a state from when the subject vehicle V stops traveling until just before ending the stopping in accordance with blocking control that is control requested by the other vehicle V and blocks a vehicle V other than the other vehicle V. Specifically, in the polling skipping process, a process of skipping a vehicle waiting due to blocking, illustrated in FIG. 6(b), is executed periodically and repeatedly.

In the process of skipping a vehicle waiting due to blocking, it is determined whether a vehicle waiting due to blocking that is a subject vehicle V in the blocking wait state is present among the vehicles V on which the polling communication is to be performed (step S51). For example, whether the subject vehicle V is a vehicle waiting due to blocking may be determined based on the state information of the subject vehicle V and the other vehicle V. For example, whether the subject vehicle V is a vehicle waiting due to blocking may be determined based on instructions related to the blocking control. For example, whether the subject vehicle V is a vehicle waiting due to blocking may be determined based on instructions from the host controller (not illustrated). The state information of the subject vehicle V and the other vehicle V may include the presence or absence of a request for the blocking control by the other vehicle V, and a start timing and an end timing of stopping traveling of the subject vehicle V.

If NO at the above-described step S51, processing in the current cycle is terminated, and the process advances to the step S51 in the next cycle. If YES at the step S51, communication with the vehicle waiting due to blocking in the polling communication is stopped (step S52). Specifically, at this step S52, the vehicle waiting due to blocking is skipped from among the vehicles V on which the polling communication is to be performed. Consequently, in the polling communication, communication with the vehicles V excluding the vehicle waiting due to blocking is performed sequentially and periodically.

The second operating state includes an area-entry wait state that is a state from when the subject vehicle V starts to stop traveling until just before ending the stopping in accordance with the area number limit control for, when the number of other vehicles V present in one of a plurality of traveling areas is a specified number or more, prohibiting entry into the corresponding traveling area. Specifically, in the polling skipping process, a process of skipping a vehicle waiting for area entry, illustrated in FIG. 6(c), is executed periodically and repeatedly.

In the process of skipping a vehicle waiting for area entry, it is determined whether a vehicle waiting for area entry that is a subject vehicle V in the area-entry wait state is present among the vehicles V on which the polling communication is to be performed (step S51). For example, whether the subject vehicle V is a vehicle waiting for area entry may be determined based on the state information of the subject vehicle V and the other vehicles V. For example, whether the subject vehicle V is a vehicle waiting for area entry may be determined based on instructions related to the area number limit control. For example, whether the subject vehicle V is a vehicle waiting for area entry may be determined based on instructions from the host controller (not illustrated). The state information of the subject vehicle V and the other vehicles V may include the presence or absence of the area number limit control, information on the current position of the subject vehicle V, and information on the current positions of the other vehicles V.

If NO at the above-described step S61, processing in the current cycle is terminated, and the process advances to the step S61 in the next cycle. If YES at the step S61, communication with the vehicle waiting for area entry in the polling communication is stopped (step S62). In other words, at the step S62, the vehicle waiting for area entry is skipped from among the vehicles V on which the polling communication is to be performed. Consequently, in the polling communication, communication with the vehicles V excluding the vehicle waiting for area entry is performed sequentially and periodically.

The predetermined operating state of a vehicle V on which the polling skipping process is to be executed includes a third operating state in which the vehicle V is performing an operation set for an indefinite period. The system controller 5 reduces the frequency of communication with the vehicle V in the third operating state in the polling communication.

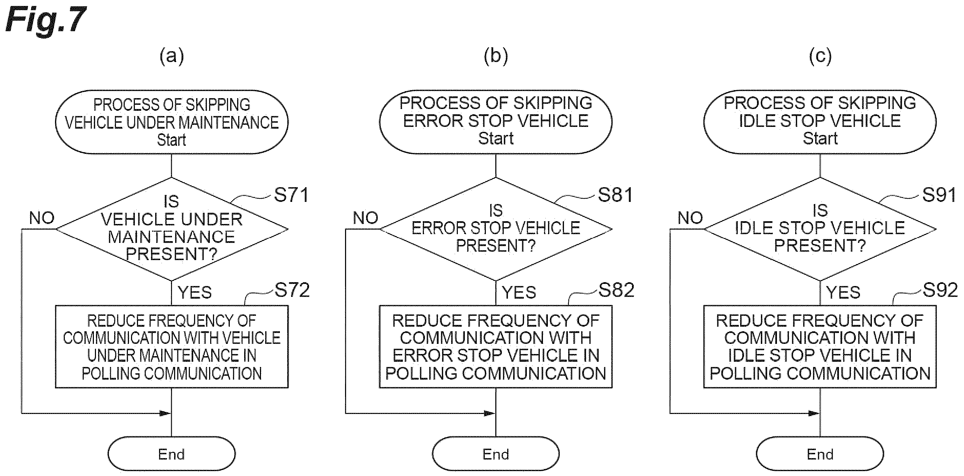

The third operating state includes an under-maintenance state that is a state in which the vehicle V is executing the maintenance mode. Specifically, in the polling skipping process, a process of skipping a vehicle under maintenance, illustrated in FIG. 7(a), is executed periodically and repeatedly.

In the process of skipping a vehicle under maintenance, it is determined whether a vehicle under maintenance that a vehicle V in the under-maintenance state is present among the vehicles V on which the polling communication is to be performed (step S71). For example, whether the vehicle V is a vehicle under maintenance may be determined based on the state information of the vehicle V. For example, whether the vehicle V is a vehicle under maintenance may be determined based on a maintenance-mode execution instruction transmitted by the system controller 5. For example, whether the vehicle V is a vehicle under maintenance may be determined based on instructions from the host controller (not illustrated). The state information of the vehicle V may include information on whether the vehicle V is executing the maintenance mode.

If NO at the above-described step S71, processing in the current cycle is terminated, and the process advances to the step S71 in the next cycle. If YES at the step S71, the frequency of communication with the vehicle under maintenance in the polling communication is reduced (step S72). In other words, at this step S72, the vehicle under maintenance is skipped from among the vehicles V on which the polling communication is to be performed such that the frequency of communication with the vehicle under maintenance becomes low. Consequently, in the polling communication, communication with the vehicles V is performed sequentially and periodically, with a reduced frequency of communication with the vehicle under maintenance. For example, at the step S72, the frequency of communication with the vehicle under maintenance is reduced such that communication with the vehicle under maintenance is performed once every five seconds in the polling communication.

The third operating state includes an error stop state that is a state in which the vehicle V is at a standstill due to an error. Specifically, in the polling skipping process, a process of skipping an error stop vehicle, illustrated in FIG. 7(b), is executed periodically and repeatedly.

In the process of skipping an error stop vehicle, it is determined whether an error stop vehicle that is a vehicle V in the error stop state is present among the vehicles V on which the polling communication is to be performed (step S81). For example, whether the vehicle V is an error stop vehicle may be determined based on the state information of the vehicle V. For example, whether the vehicle V is an error stop vehicle may be determined based on an error stop instruction transmitted by the system controller 5. For example, whether the vehicle V is an error stop vehicle may be determined based on instructions from the host controller (not illustrated). The state information of the vehicle V may include information on whether the state of the vehicle V is abnormal and whether the vehicle V has stopped traveling and is at a standstill.

If NO at the above-described step S81, processing in the current cycle is terminated, and the process advances to the step S81 in the next cycle. If YES at the step S81, the frequency of communication with the error stop vehicle in the polling communication is reduced (step S82). In other words, at this step S82, the error stop vehicle is skipped from among the vehicles V on which the polling communication is to be performed such that the frequency of communication with the error stop vehicle becomes low. Consequently, in the polling communication, communication with the vehicles V is performed sequentially and periodically, with a reduced frequency of communication with the error stop vehicle. For example, at the step S82, the frequency of communication with the error stop vehicle is reduced such that communication with the error stop vehicle is performed once every 10 seconds in the polling communication.

The third operating state includes an idle stop state that is a state in which the vehicle is at a standstill in an idle state. Specifically, in the polling skipping process, a process of skipping an idle stop vehicle, illustrated in FIG. 7(c), is executed periodically and repeatedly.

In the process of skipping an idle stop vehicle, it is determined whether an idle stop vehicle that is a vehicle V in the idle stop state is present among the vehicles V on which the polling communication is to be performed (step S91). For example, whether the vehicle V is an idle stop vehicle may be determined based on the state information of the vehicle V. For example, whether the vehicle V is an idle stop vehicle may be determined based on an idle stop instruction transmitted by the system controller 5. For example, whether the vehicle V is an idle stop vehicle may be determined based on instructions from the host controller (not illustrated). The state information of the vehicle V may include information on whether the vehicle V is in the idle state and whether the vehicle V has stopped traveling and is at a standstill.

If NO at the above-described step S91, processing in the current cycle is terminated, and the process advances to the step S91 in the next cycle. If YES at the step S91, the frequency of communication with the idle stop vehicle in the polling communication is reduced (step S92). In other words, at this step S92, the idle stop vehicle is skipped from among the vehicles V on which the polling communication is to be performed such that the frequency of communication with the idle stop vehicle becomes low. Consequently, in the polling communication, communication with the vehicles V is performed sequentially and periodically, with a reduced frequency of communication with the idle stop vehicle. For example, at the step S92, the frequency of communication with the idle stop vehicle is reduced such that communication with the idle stop vehicle is performed once every five seconds in the polling communication.

In the conveyance system SYS described above, the polling skipping process can stop communication with a vehicle V in the predetermined operating state in the polling communication or reduce the frequency thereof. This makes it possible to reduce the time required for communication with a vehicle V in the predetermined operating state by skipping communication with the vehicle V in the given operating state in the polling communication. Thus, the cycle of the polling communication, that is, one cycle time of the polling communication (see formula below) can be shortened. Consequently, the notification communication speed (bps), for example, can be increased for each required vehicle V (vehicle V that is not in the predetermined operating state) to enable smooth control.

$$1 \text{ cycle time} = t \cdot N$$

t: response time per vehicle, N: the number of vehicles on which the polling communication is to be performed

In the conveyance system SYS, the predetermined operating state includes the first operating state in which the vehicle V stops traveling and performs an operation other than traveling. In this case, the time required for communication with the vehicle V in the first operating state in the polling communication can be reduced.

In the conveyance system SYS, communication with the vehicle V in the first operating state in the polling communication is stopped for a period based on time required for the operation in the first operating state. In this case, the cycle of the polling communication can be reduced for the period based on the time required for the operation in the first operating state.

In the conveyance system SYS, the first operating state includes the transferring state. In this case, the time required for communication with the transferring vehicle in the polling communication can be reduced. In the conveyance system SYS, the first operating state includes the charging state. In this case, the time required for communication with the vehicle being charged in the polling communication can be reduced. In the conveyance system SYS, the first operating state includes the turning state. In this case, the time required for communication with the turning vehicle in the polling communication can be reduced.

In the conveyance system SYS, the predetermined operating state includes the second operating state in which the vehicle V stops traveling due to an influence of an operation of another vehicle V. In this case, the time required for communication with the vehicle V in the second operating state in the polling communication can be reduced.

In the conveyance system SYS, communication with the vehicle V in the second operating state in the polling communication is stopped while the influence of the operation of the other vehicle V is being exerted, or until just before the influence disappears. In this case, the cycle of the polling communication can be reduced for the period when the influence of the operation of the other vehicle V is being exerted, or the period until just before the influence disappears.

In the conveyance system SYS, the second operating state includes the transfer wait state. In this case, the time required for communication with the transfer waiting vehicle in the polling communication can be reduced. In the conveyance system SYS, the second operating state includes the blocking wait state. In this case, the time required for communication with the vehicle waiting due to blocking in the polling communication can be reduced. In the conveyance system SYS, the second operating state includes the area-entry wait state. In this case, the time required for communication with the vehicle waiting for area entry in the polling communication can be reduced.

In the conveyance system SYS, the predetermined operating state includes the third operating state in which the vehicle V is performing an operation set for an indefinite period. In this case, the time required for communication with the vehicle V in the third operating state in the polling communication can be reduced.

In the conveyance system SYS, the frequency of communication with the vehicle V in the third operating state in the polling communication is reduced. In this case, the frequency of reducing the cycle for the time required for communication with the vehicle V in the third operating state can be increased in the polling communication. Further in this case, the communication with the vehicle V in the third operating state in the polling communication is not stopped, and thus the communication with the vehicle V can be maintained, which is effective for the vehicle V to return from the third operating state to the normal operating state.

In the conveyance system SYS, the third operating state includes the under-maintenance state. In this case, the time required for communication with the vehicle under maintenance in the polling communication can be reduced. In the conveyance system SYS, the third operating state includes the error stop state. In this case, the time required for communication with the error stop vehicle in the polling communication can be reduced. In the conveyance system SYS, the third operating state includes the idle stop state. In this case, the time required for communication with the idle stop vehicle in the polling communication can be reduced.

The conveyance system SYS includes the rail R on which a plurality of vehicles V travel, which constitutes what is called a grid system. By this configuration, traveling paths for the vehicle V can be selected easily and flexibly, whereby traffic congestion can be prevented and conveyance efficiency can be improved.

Simulations were performed on the conveyance system SYS described above to verify the reduction ratio of the cycle of the polling communication. As results of the simulations, it could be confirmed that the cycle of the polling communication was reduced by more than 30% (about 31%).

Whether the polling skipping process is being executed in the polling communication can be checked based on a log of the system controller 5, for example. In the conveyance system SYS, execution and suspension of the polling skipping process may be selected by, for example, input operated by a user via an operation input unit, and the execution and suspension of the polling skipping process may be controlled based on the result of the selection.

Although the embodiment has been described above, an aspect of the present invention is not limited to the embodiment, and various modifications may be made within the scope not departing from the gist of the invention.

In the above embodiment, the predetermined operating state is not limited to a particular one. The predetermined operating state may include at least one of the first operating state, the second operating state, and the third operating state, and may include another operating state. Information to be used in determining whether the vehicle V is in the predetermined operating state is not limited to a particular one, and various types of information may be used.

In the above embodiment, the first operating state is not limited to a particular one. The first operating state may include at least one of the transferring state, the charging state, and the turning state, and may further include another state. In the above embodiment, the second operating state is not limited to a particular one. The second operating state may include at least one of the transfer wait state, the blocking wait state, and the area-entry wait state, and may further include another state. In the above embodiment, the third operating state is not limited to a particular one. The third operating state may include at least one of the under-maintenance state, the error stop state, and the idle stop state, and may further include another state.

In the above embodiment, the grid system is adopted as the conveyance system SYS. However, the conveyance system SYS is not limited to the grid system. For example, as the conveyance system, automated guided vehicles (AGVs) may be adopted, or various known systems configured to travel on a grid-patterned traveling path may be adopted. In the above embodiment, the vehicle V holds an article M below the rail R. However, the body section 10 may be disposed above the rail R and hold an article M above the rail R.

**Reference Signs List**

| 2 | grid cell |
| 5 | system controller (controller) |
| 13 | article holding unit |
| 18 | transfer device |
| 20 | traveling unit |
| 21 | traveling wheel |
| M | article |
| R | rail (grid-patterned track) |
| SYS | conveyance system |
| V | vehicle (subject vehicle, another vehicle) |

**Claims**

1. A conveyance system (SYS) comprising:

   a plurality of vehicles (V); and
   a system controller (5) configured to control the vehicles (V), wherein
   each vehicle of the plurality of vehicles (5) comprises a vehicle controller (50) configured to control the vehicle (V), the vehicle controller (50) being configured to generate and update state information and to transmit the state information to the system controller (5),
   the system controller (5) is configured to perform periodic communication for communicating with the vehicles (V) sequentially and periodically, and
   **characterized in that**, when at least one of the vehicles (V) is in a predetermined operating state, the system controller (5) is configured to stop communicating with the at least one of the vehicles (V) in the periodic communication or reduces a frequency of communication with the at least one of the vehicles (V) in the periodic communication.

2. The conveyance system (SYS) according to claim 1, wherein the predetermined operating state includes a first operating state in which the vehicle (V) stops traveling and performs an operation other than traveling.

3. The conveyance system (SYS) according to claim 2, wherein communication with the vehicle (V) in the first operating state in the periodic communication is stopped for a period based on time required for an operation in the first operating state.

4. The conveyance system (SYS) according to claim 2 or 3, wherein the first operating state includes a transferring state that is a state from when the vehicle (V) starts transferring an article (M) until just before completing the transferring.

5. The conveyance system (SYS) according to one of claims 2 to 4, wherein the first operating state includes a charging state that is a state from when the vehicle (V) starts being charged until just before completing being charged.

6. The conveyance system (SYS) according to one of claims 2 to 5, wherein the first operating state includes a turning state that is a state from when the vehicle (V) starts turning until just before a timing when the vehicle (V) needs to request blocking control to prohibit another vehicle (V) from entering a predetermined area into which the vehicle (V) enters after the turning.

7. The conveyance system (SYS) according to one of claims 1 to 6, wherein the predetermined operating state includes a second operating state in which the vehicle (V) stops traveling due to an influence of an operation of another vehicle (V).

8. The conveyance system (SYS) according to claim 7, wherein communication with the vehicle (V) in the second operating state in the periodic communication is stopped while the influence of the operation of the other vehicle (V) is being exerted, or until just before the influence disappears.

9. The conveyance system (SYS) according to claim 7 or 8, wherein the second operating state includes a transfer wait state that is a state in which the vehicle (V) stops traveling from when the other vehicle (V) starts transferring an article (M) until just before completing the transferring.

10. The conveyance system (SYS) according to one of claims 7 to 9, wherein the second operating state includes a blocking wait state that is a state from when the vehicle (V) starts to stop traveling until just before ending the stopping in accordance with blocking control that is control requested by the other vehicle (V) and that prohibits the vehicle (V) other than the other vehicle (V) from entering a predetermined area.

11. The conveyance system (SYS) according to one of claims 7 to 10, wherein the second operating state includes an area-entry wait state that is a state from when the vehicle (V) starts to stop traveling until just before ending the stopping in accordance with area number limit control for, when the number of other vehicles (V) present in one of a plurality of traveling areas is a specified number or more, prohibiting entry into the corresponding traveling area.

12. The conveyance system (SYS) according to one of claims 1 to 11, wherein the predetermined operating state includes a third operating state in which the vehicle (V) is performing an operation set for an indefinite period.

13. The conveyance system (SYS) according to claim 12, wherein the frequency of communication with the vehicle (V) in the third operating state in the periodic communication is reduced.

14. The conveyance system (SYS) according to claim 12 or 13, wherein the third operating state includes at least one of an under-maintenance state that is a state in which the vehicle (V) is executing a maintenance mode, an error stop state that is a state in which the vehicle (V) is at a standstill due to an error, and an idle stop state that is a state in which the vehicle (V) is at a standstill in an idle state.

15. The conveyance system (SYS) according to one of claims 1 to 14, comprising a grid-patterned track on which the vehicles (V) travel.

**Patentansprüche**

1. Ein Beförderungssystem (SYS), das folgende Merkmale aufweist:

   eine Mehrzahl von Fahrzeugen (V); und
   eine Systemsteuerung (5), die dazu konfiguriert ist, die Fahrzeuge (V) zu steuern, wobei jedes Fahrzeug der Mehrzahl von Fahrzeugen (5) eine Fahrzeugsteuerung (50) aufweist, die dazu konfiguriert ist, das Fahrzeug (V) zu steuern, wobei die Fahrzeugsteuerung (50) dazu konfiguriert ist, Zustandsinformationen zu erzeugen und zu aktualisieren und die Zustandsinformationen an die Systemsteuerung (5) zu senden,
   wobei die Systemsteuerung (5) dazu konfiguriert ist, eine periodische Kommunikation zum Kommunizieren mit den Fahrzeugen (V) auf sequentielle Weise und periodische Weise auszuführen, und

**dadurch gekennzeichnet, dass** dann, wenn zumindest eines der Fahrzeuge (V) in einem vorbestimmten Tätigkeitszustand ist, die Systemsteuerung (5) dazu konfiguriert ist, das Kommunizieren mit dem zumindest einen der Fahrzeuge (V) in der periodischen Kommunikation zu stoppen oder eine Frequenz der Kommunikation mit dem zumindest einen der Fahrzeuge (V) in der periodischen Kommunikation zu reduzieren.

2. Das Beförderungssystem (SYS) gemäß Anspruch 1, wobei der vorbestimmte Tätigkeitszustand einen ersten Tätigkeitszustand umfasst, in dem das Fahrzeug (V) eine Bewegung stoppt und eine andere Tätigkeit als eine Bewegung ausführt.

3. Das Beförderungssystem (SYS) gemäß Anspruch 2, wobei eine Kommunikation mit dem Fahrzeug (V) in dem ersten Tätigkeitszustand in der periodischen Kommunikation für einen Zeitraum auf der Basis der Zeit, die für eine Tätigkeit in dem ersten Tätigkeitszustand erforderlich ist, gestoppt wird.

4. Das Beförderungssystem (SYS) gemäß Anspruch 2 oder 3, wobei der erste Tätigkeitszustand einen Transferzustand umfasst, der ein Zustand ab dem Zeitpunkt, wenn das Fahrzeug (V) mit einem Transfer eines Artikel (M) beginnt, bis kurz vor dem Abschluss des Transfers ist.

5. Das Beförderungssystem (SYS) gemäß einem der Ansprüche 2 bis 4, wobei der erste Tätigkeitszustand einen Ladezustand umfasst, der ein Zustand ab dem Zeitpunkt, wenn eine Ladung des Fahrzeug (V) begonnen wird, bis kurz vor dem Abschluss der Ladung ist.

6. Das Beförderungssystem (SYS) gemäß einem der Ansprüche 2 bis 5, wobei der erste Tätigkeitszustand einen Drehzustand umfasst, der ein Zustand ab dem Zeitpunkt, wenn das Fahrzeug (V) mit einer Drehung beginnt, bis kurz vor einem Zeitpunkt ist, wenn das Fahrzeug (V) eine Blockierungssteuerung anfordern muss, um zu verhindern, dass ein anderes Fahrzeug (V) in einen vorbestimmten Bereich eintritt, in den das Fahrzeug (V) nach der Drehung eintritt.

7. Das Beförderungssystem (SYS) gemäß einem der Ansprüche 1 bis 6, wobei der vorbestimmte Tätigkeitszustand einen zweiten Tätigkeitszustand umfasst, in dem das Fahrzeug (V) aufgrund eines Einflusses einer Tätigkeit eines anderen Fahrzeuges (V) eine Bewegung stoppt.

8. Das Beförderungssystem (SYS) gemäß Anspruch 7, wobei eine Kommunikation mit dem Fahrzeug (V) in dem zweiten Tätigkeitszustand in der periodischen Kommunikation gestoppt wird, während der Einfluss der Tätigkeit des anderen Fahrzeugs (V) andauert oder bis kurz bevor der Einfluss verschwindet.

9. Das Beförderungssystem (SYS) gemäß Anspruch 7 oder 8, wobei der zweite Tätigkeitszustand einen Übertragungswartezustand umfasst, der ein Zustand ist, in dem das Fahrzeug (V) eine Bewegung stoppt, ab dem Zeitpunkt, wenn das andere Fahrzeug (V) mit einem Transfer des Artikels (M) beginnt, bis kurz vor dem Abschluss des Transfers.

10. Das Beförderungssystem (SYS) gemäß einem der Ansprüche 7 bis 9, wobei der zweite Tätigkeitszustand einen Blockierungswartezustand umfasst, der ein Zustand ab dem Zeitpunkt, wenn das Fahrzeug (V) mit dem Stoppen einer Bewegung beginnt, bis kurz vor Abschluss des Stoppens gemäß einer Blockierungssteuerung ist, welche eine Steuerung ist, die von dem anderen Fahrzeug (V) angefordert wird und die verhindert, dass das Fahrzeug (V) außer dem anderen Fahrzeug (V) in einen vorbestimmten Bereich eintritt.

11. Das Beförderungssystem (SYS) gemäß einem der Ansprüche 7 bis 10, wobei der zweite Tätigkeitszustand einen Bereichseintrittswartezustand umfasst, der ein Zustand ab dem Zeitpunkt, wenn das Fahrzeug (V) mit dem Stoppen einer Bewegung beginnt, bis kurz vor Beendigung des Stoppens gemäß einer Bereichsanzahlbegrenzungssteuerung ist, um dann, wenn die Anzahl anderer Fahrzeuge (V), die in einer Mehrzahl von Bewegungsbereichen vorhanden sind, eine vorbestimmte Anzahl oder größer ist, einen Eintritt in den entsprechenden Bewegungsbereich zu verhindern.

12. Das Beförderungssystem (SYS) gemäß einem der Ansprüche 1 bis 11, wobei der vorbestimmte Tätigkeitszustand einen dritten Tätigkeitszustand umfasst, in dem das Fahrzeug (V) eine für einen unbegrenzten Zeitraum eingestellte Tätigkeit ausführt.

13. Das Beförderungssystem (SYS) gemäß Anspruch 12, wobei die Frequenz einer Kommunikation mit dem Fahrzeug (V) in dem dritten Tätigkeitszustand in der periodischen Kommunikation reduziert wird.

14. Das Beförderungssystem (SYS) gemäß Anspruch 12, wobei der dritte Tätigkeitszustand einen In-Wartung-Zustand, der ein Zustand ist, in dem das Fahrzeug (V) einen Wartungsmodus ausführt, einen Fehlerstoppzustand, der ein Zustand ist, in dem das Fahrzeug (V) aufgrund eines Fehlers in Stillstand ist, und/oder einen Ruhestoppzustand umfasst, der ein Zustand ist, in dem das Fahrzeug (V) in einem Ruhezustand in Stillstand ist.

15. Das Beförderungssystem (SYS) gemäß einem der Ansprüche 1 bis 14, das eine Bahn mit Gittermuster aufweist, auf der sich die Fahrzeuge (V) bewegen.

## Revendications

1. Système de transport (SYS) comprenant :

une pluralité de véhicules (V) ; et un contrôleur de système (5) configuré pour contrôler les véhicules (V), dans lequel chaque véhicule de la pluralité de véhicules (5) comprend un contrôleur de véhicule (50) configuré pour contrôler le véhicule (V), le contrôleur de véhicule (50) étant configuré pour générer et mettre à jour des informations d'état et pour transmettre ces informations d'état au contrôleur de système (5), le contrôleur de système (5) est configuré pour effectuer des communications périodiques pour communiquer avec les véhicules (V) de manière séquentielle et périodique, et **caractérisé en ce que**, lorsqu'au moins l'un des véhicules (V) se trouve dans un état de fonctionnement prédéterminé, le contrôleur de système (5) est configuré pour arrêter la communication avec l'au moins un des véhicules (V) dans la communication périodique ou réduit une fréquence de communication avec l'au moins un des véhicules (V) dans la communication périodique.

2. Système de transport (SYS) selon la revendication 1, dans lequel l'état de fonctionnement prédéterminé inclut un premier état de fonctionnement dans lequel le véhicule (V) arrête de se déplacer et effectue une opération autre que le déplacement.

3. Système de transport (SYS) selon la revendication 2, dans lequel la communication avec le véhicule (V) dans le premier état de fonctionnement dans la communication périodique est arrêtée pendant une durée en fonction d'un temps nécessaire à une opération dans le premier état de fonctionnement.

4. Système de transport (SYS) selon la revendication 2 ou 3, dans lequel le premier état de fonctionnement inclut un état de transfert qui est un état à partir du moment où le véhicule (V) commence à transférer un article (M) jusqu'à juste avant la fin du transfert.

5. Système de transport (SYS) selon l'une des revendications 2 à 4, dans lequel le premier état de fonctionnement inclut un état de charge qui est un état à partir du moment où le véhicule (V) commence à être chargé jusqu'à juste avant la fin de la charge.

**6.** Système de transport (SYS) selon l'une des revendications 2 à 5, dans lequel le premier état de fonctionnement inclut un état de virage qui est un état à partir du moment où le véhicule (V) commence à tourner jusqu'à juste avant un moment où le véhicule (V) doit demander un contrôle de blocage afin d'empêcher un autre véhicule (V) d'entrer dans une zone prédéterminée dans laquelle le véhicule (V) entre après le virage.

**7.** Système de transport (SYS) selon l'une des revendications 1 à 6, dans lequel l'état de fonctionnement prédéterminé inclut un deuxième état de fonctionnement dans lequel le véhicule (V) arrête de se déplacer en raison d'une influence d'une opération d'un autre véhicule (V).

**8.** Système de transport (SYS) selon la revendication 7, dans lequel la communication avec le véhicule (V) dans le deuxième état de fonctionnement dans la communication périodique est arrêtée pendant que l'influence de l'opération de l'autre véhicule (V) est exercée, ou jusqu'à juste avant que cette influence ne disparaisse.

**9.** Système de transport (SYS) selon la revendication 7 ou 8, dans lequel le deuxième état de fonctionnement inclut un état d'attente de transfert qui est un état dans lequel le véhicule (V) arrête de se déplacer à partir du moment où l'autre véhicule (V) commence à transférer un article (M) jusqu'à juste avant la fin du transfert.

**10.** Système de transport (SYS) selon l'une des revendications 7 à 9, dans lequel le deuxième état de fonctionnement inclut un état d'attente de blocage qui est un état à partir du moment où le véhicule (V) commence à arrêter de se déplacer jusqu'à juste avant la fin de l'arrêt conformément à un contrôle de blocage qui est un contrôle demandé par l'autre véhicule (V) et qui interdit au véhicule (V) autre que l'autre véhicule (V) d'entrer dans une zone prédéterminée.

**11.** Système de transport (SYS) selon l'une des revendications 7 à 10, dans lequel le deuxième état de fonctionnement inclut un état d'attente d'entrée dans une zone qui est un état à partir du moment où le véhicule (V) commence à arrêter de se déplacer jusqu'à juste avant la fin de l'arrêt conformément à un contrôle de limitation de nombre dans une zone qui, lorsque le nombre d'autres véhicules (V) présents dans l'une d'une pluralité de zones de déplacement atteint ou dépasse un nombre spécifié, interdit l'entrée dans la zone de déplacement correspondante.

**12.** Système de transport (SYS) selon l'une des revendications 1 à 11, dans lequel l'état de fonctionnement prédéterminé inclut un troisième état de fonctionnement dans lequel le véhicule (V) effectue une opération définie pour une durée indéterminée.

**13.** Système de transport (SYS) selon la revendication 12, dans lequel la fréquence de communication avec le véhicule (V) dans le troisième état de fonctionnement dans la communication périodique est réduite.

**14.** Système de transport (SYS) selon la revendication 12 ou 13, dans lequel le troisième état de fonctionnement inclut au moins l'un d'un état de maintenance en cours qui est un état dans lequel le véhicule (V) exécute un mode de maintenance, d'un état d'arrêt erreur qui est un état dans lequel le véhicule (V) est immobile en raison d'une erreur, et d'un état d'arrêt au ralenti qui est un état dans lequel le véhicule (V) est immobile en état de ralenti.

**15.** Système de transport (SYS) selon l'une des revendications 1 à 14, présentant une voie à motif de grilles sur laquelle les véhicules (V) se déplacent.

# Fig.1

EP 4 354 246 B1

# Fig.2

Fig.3 SYS

# Fig.4

```
                              5
  ┌─────────────────────────────────────────────────────────────────────┐
  │                      SYSTEM CONTROLLER                                │
  └─────────────────────────────────────────────────────────────────────┘
          ↕        ↑                                           ↕    ↑
                              V1(V)                              Vn(V)

  ┌──────────────────────────────────────────────┐         ┌──────────────┐
  │              FIRST VEHICLE                     │  • • •  │ n-TH VEHICLE │
  │                                                │         └──────────────┘
  │  ┌────────────────┐   ┌──────────────────┐     │
  │10│  BODY SECTION  │   │  TRAVELING UNIT  │20   │
  │  └────────────────┘   └──────────────────┘     │
  │                                                │
  │  ┌────────────────┐                            │
  │38│   POSITION     │                            │
  │  │   DETECTOR     │                 50         │
  │  └────────────────┘                            │
  │  ┌──────────────────────────────────────────┐ │
  │  │          VEHICLE CONTROLLER              │ │
  │  └──────────────────────────────────────────┘ │
  └──────────────────────────────────────────────┘
```

20

**Fig.5**

(a)

PROCESS OF SKIPPING TRANSFERRING VEHICLE
Start

IS TRANSFERRING VEHICLE PRESENT? — S11

NO

YES — S12

STOP COMMUNICATION WITH TRANSFERRING VEHICLE IN POLLING COMMUNICATION

End

(b)

PROCESS OF SKIPPING VEHICLE BEING CHARGED
Start

IS VEHICLE BEING CHARGED PRESENT? — S21

NO

YES — S22

STOP COMMUNICATION WITH VEHICLE BEING CHARGED IN POLLING COMMUNICATION

End

(c)

PROCESS OF SKIPPING TURNING VEHICLE
Start

IS TURNING VEHICLE PRESENT? — S31

NO

YES — S32

STOP COMMUNICATION WITH TURNING VEHICLE IN POLLING COMMUNICATION

End

EP 4 354 246 B1

**Fig.6**

(a)

PROCESS OF SKIPPING VEHICLE WAITING FOR TRANSFER
Start

S41 — IS VEHICLE WAITING FOR TRANSFER PRESENT?

NO → End

YES → S42 — STOP COMMUNICATION WITH VEHICLE WAITING FOR TRANSFER IN POLLING COMMUNICATION → End

(b)

PROCESS OF SKIPPING VEHICLE WAITING DUE TO BLOCKING
Start

S51 — IS VEHICLE WAITING DUE TO BLOCKING PRESENT?

NO → End

YES → S52 — STOP COMMUNICATION WITH VEHICLE WAITING DUE TO BLOCKING IN POLLING COMMUNICATION → End

(c)

PROCESS OF SKIPPING VEHICLE WAITING FOR AREA ENTRY
Start

S61 — IS VEHICLE WAITING FOR AREA ENTRY PRESENT?

NO → End

YES → S62 — STOP COMMUNICATION WITH VEHICLE WAITING FOR AREA ENTRY IN POLLING COMMUNICATION → End

**Fig.7**

(a)

PROCESS OF SKIPPING
VEHICLE UNDER MAINTENANCE
Start

S71 — IS VEHICLE UNDER MAINTENANCE PRESENT?

NO

YES — S72 — REDUCE FREQUENCY OF COMMUNICATION WITH VEHICLE UNDER MAINTENANCE IN POLLING COMMUNICATION

End

(b)

PROCESS OF SKIPPING
ERROR STOP VEHICLE
Start

S81 — IS ERROR STOP VEHICLE PRESENT?

NO

YES — S82 — REDUCE FREQUENCY OF COMMUNICATION WITH ERROR STOP VEHICLE IN POLLING COMMUNICATION

End

(c)

PROCESS OF SKIPPING
IDLE STOP VEHICLE
Start

S91 — IS IDLE STOP VEHICLE PRESENT?

NO

YES — S92 — REDUCE FREQUENCY OF COMMUNICATION WITH IDLE STOP VEHICLE IN POLLING COMMUNICATION

End

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2019012500 A
- WO 2020235196 A1
- JP 2004246418 A